# EUROPEAN PATENT APPLICATION

(11) **EP 3 489 327 A1**
(43) Date of publication of application: **29.05.2019**
(21) Application number: 18197817.2
(22) Date of filing: 01.09.2016
(51) Int. Cl.: C09K 11/61, C09K 11/02, C09K 11/08, H01L 33/50, C09K 11/80

(54) **PHOSPHOR CONVERTED WHITE LIGHT EMITTING DEVICES**

(30) Priority: 10.09.2015 US 201562216985 P; 02.06.2016 US 201662344930 P
(62) Divisional of application: 16844914.8
(71) Applicant: Intematix Corporation, Fremont CA 94538 (US)
(72) Inventor: YANG, Haitao, San Jose, CA California 95123 (US); CHAI, Binghua, Fremont, CA California 94539 (US)
(74) Representative: Birdi, Sandeep Singh

(57) **Abstract**

There is provided a white light emitting device comprising: a solid-state light emitter operable to generate blue light with a dominant wavelength in range 440 nm to 470 nm; a yellow to green-emitting phosphor excitable by blue light and operable to emit light with a peak emission wavelength in a range 500 nm to 575 nm; a red-emitting manganese-activated potassium hexafluorosilicate phosphor excitable by blue light and operable to emit light with a peak emission wavelength between 631nm and 632nm; and an orange to red-emitting phosphor excitable by blue light and operable to generate light with a peak emission wavelength in a range 575 nm to 600 nm, wherein the device is operable to generate white light with a Correlated Color Temperature of between about 2700K and about 3000K and wherein over a wavelength range 460 nm to 600 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.3.

## Description

### CROSS-REFERENCE TO RELATED APPLICATIONS

This application claims the benefit of priority to U.S. Provisional Application No. 62/216,985, filed 10 September 2015 and U.S. Provisional application No. 62/344,930, filed 2 June 2016, each of which are hereby incorporated by reference in their entirety.

### FIELD

This disclosure relates to phosphor converted white light emitting devices and photoluminescence compounds. In particular, although not exclusively, embodiments of the invention concern white light emitting devices and photoluminescence compounds for generating white light with a high Color Rendering Index (CRI) that is 90 and higher for general lighting. Further, embodiments of the invention relate to white light emitting devices and compounds for use in backlights for high color gamut displays.

### BACKGROUND

Recently, white light emitting LEDs ("white LEDs") have become more popular and more commonly used to replace conventional fluorescent, compact fluorescent and incandescent light sources. White LEDs generally include one or more photoluminescence materials (typically inorganic phosphor materials), which absorb a portion of the radiation emitted by the LED and re-emit light of a different color (wavelength). The phosphor material may be provided as a layer on, or incorporated within a wavelength conversion component that is located remotely from the LED. Typically, the LED generates blue light and the phosphor(s) absorbs a percentage of the blue light and re-emits yellow, green, or a combination of green and yellow light. The portion of the blue light generated by the LED that is not absorbed by the phosphor material combined with the light emitted by the phosphor provides light which appears to the eye as being white in color. White LEDs have also find widespread use in liquid crystal display backlighting such as for example televisions, computer monitors, laptops, tablet devices and smart phones.

To generate white light with a higher CRI, for example 80 or higher, it is known to additionally include red and/or orange light emitting phosphors in the wavelength conversion component.

The present invention concerns improvements relating to white light emitting devices and display backlights with improved luminous efficacy, color rendering and/or color gamut.

### SUMMARY OF THE INVENTION

Embodiments of the invention concern white light emitting devices that include wavelength conversion phosphors for general light and display backlights.

According to an embodiment of the invention a white light emitting device comprises: a solid-state light emitter operable to generate blue light with a dominant wavelength in a range 440 nm to 470 nm; a yellow to green-emitting phosphor excitable by blue light and operable to generate light with a peak emission wavelength in a range 500 nm to 575 nm; a red-emitting manganese-activated fluoride phosphor with an index of refraction of about 1.4 (i.e. n≈1.39 to ≈1.43); and a light transmissive material with an index of refraction of 1.40 to 1.43 comprising a mixture of the yellow to green-emitting phosphor and red-emitting manganese-activated fluoride phosphor. Typically, the mixture of the yellow to green-emitting and red-emitting manganese-activated fluoride phosphors are incorporated (dispersed) in and homogeneously distributed throughout the light transmissive material.

Incorporating the yellow to green-emitting and red-emitting manganese-activated fluoride phosphors in a light transmissive material with an index of refraction comparable with the index of refraction of the red-emitting manganese-activated fluoride phosphor is found to result in a substantial increase (about 5% increase) in luminous flux emitted by the device as compared with devices that use other light transmissive materials with a higher index of refraction. It is postulated that the increase in luminous flux results from the index of refraction (n≈1.4) of the light transmissive material increasing red light extraction (and/or excitation) of the red-emitting manganese-activated fluoride phosphor which has a comparable index of refraction of about 1.4. In one embodiment, the red-emitting manganese-activated fluoride phosphor comprises a red-emitting manganese-activated potassium hexafluorosilicate phosphor whose composition can be represented by the chemical formula K₂SiF₆:Mn⁴⁺.K₂SiF₆:Mn⁴⁺ has an index of refraction of about 1.399. It is expected that the present invention finds utility to other red-emitting manganese-activated fluoride phosphors with an index of refraction of about 1.4 and it is believed that manganese-activated fluoride phosphors having these properties may include K₂TiF₆:Mn⁴⁺, K₂SnF₆:Mn⁴, Na₂TiF₆:Mn⁴⁺, Na₂ZrF₆:Mn⁴⁺, Cs₂SiF₆:Mn⁴⁺, Cs₂TiF₆:Mn4⁺, Rb₂SiF₆:Mn⁴⁺, Rb₂TiF₆:Mn⁴⁺, K₃ZrF₇:Mn⁴⁺, K₃NbF₇:Mn⁴⁺, K₃TaF₇:Mn⁴⁺, K₃GdF₆:Mn⁴⁺, K₃LaF₆:Mn⁴⁺ and K₃YF₆:Mn⁴⁺.

In some embodiments the light transmissive material, a methyl-based silicone such as a dimethylsiloxane or polydimethylsiloxane.

The yellow to green-emitting phosphor comprises any phosphor excitable by blue light and operable to emit light with a peak wavelength 500 nm to 575 nm. In one embodiment intended for general lighting, the yellow to green-emitting phosphor comprises a cerium-activated garnet phosphor such as a cerium-activated yttrium aluminate (YAG) phosphor or a cerium-activated lutetium aluminate (LuAG) phosphor. An example of a YAG phosphor can be represented by the chemical formula Y₃₋ₓ(Al_{1-y}Ga_{y})₅O₁₂:Ceₓ where 0.01 < x < 0.2 and 0 < y < 2.5. An example of a LuAG phosphor can be represented by the chemical formula Lu₃₋ₓ(Al_{1-y}M_{y})₅O₁₂:Ceₓ where M is at least one of Mg, Ca, Sr, Ba, Ga and combinations thereof, 0.01 < x < 0.2 and 0 < y < 1.5. In one embodiment M=Ga and the LuAG phosphor can be represented by the chemical formula Lu₃₋ₓ(Al_{1-y}Ga_{y})₅O₁₂:Ceₓ The YAG or LuAG phosphors can further comprise a halogen such as F, Cl or Br.

In another embodiment intended for general lighting the green-emitting phosphor comprises a europium activated silicate phosphor represented by the chemical formula A₂SiO₄:Eu where A is at least one of Mg, Ca, Sr, Ba and combinations thereof. The europium-activated silicate phosphor can further comprise a halogen such as F, Cl or Br. The yellow to green-emitting phosphor comprises a cerium-activated garnet phosphor.

For display backlighting the yellow to green-emitting phosphor preferably comprises a narrow-band green-emitting phosphor with a peak emission wavelength that is matched to the green color filter of the display, typically 535 nm. In this specification a narrow-band emitting phosphor refers to a phosphor whose emission peak has a FWHM (Full Width Half Maximum) of about 50 nm of less. In an embodiment the yellow to green-emitting phosphor comprises a europium-activated β-SiAlON phosphor with a FWHM 50 - 52 nm. An example of a europium-activated β-SiAlON phosphor is represented by the chemical formula MₓSi₁₂₋₍ₘ₊ₙ₎Alₘ₊ₙOₙN₁₆₋ₙ:Eu where M is at least one Mg, Ca, Sr and combinations thereof, 0.01 < x < 0.1, 0.01 < m < 0.12 and 0.1 < n < 0.5. In another embodiment the yellow to green-emitting phosphor comprises a europium-activated sulfide phosphor represented by the general formula SrGa₂S₄:Eu with a FWHM 46 - 48 nm.

For general lighting, the white light emitting device can further comprise an orange to red-emitting phosphor excitable by blue light and operable to emit light with a peak emission wavelength in a range 580 nm to 620 nm. The inclusion of a third orange to red-emitting phosphor has been found to provide a significant increase in brightness (about 8%), an increase in the general CRI (Ra), an increase in the CRI (R9) and an increase the luminous efficacy (LE) of the device.

The light transmissive material comprises a mixture of the yellow to green-emitting phosphor, red-emitting manganese-activated fluoride phosphor and orange to red-emitting phosphor.

In some embodiments the orange-emitting phosphor comprises a europium-activated silicon-nitride phosphor such as a CASN (1-1-1-3) or 2-5-8 silicon-nitride phosphors having the general crystalline structure of M'₂Si₅N₈:Eu where M is at least one of Mg, Ca, Sr, Ba, and Zn.

In an embodiment the CASN phosphor can be represented by the chemical formula (Ca₁₋ₓSrₓ)AlSiN₃:Eu where 0.5 < x ≤ 1. In an embodiment the 2-5-8 silicon-nitride phosphor can be represented by the chemical formula Ba₂₋ₓSrₓSi₅N₈:Eu where 0 ≤ x ≤ 2. Preferably, the orange-emitting phosphor generates light with a peak emission wavelength in a range 590 nm to 610 nm.

The present invention finds particular application to high CRI devices and the device is advantageously operable to generate white light with a General CRI (Ra) of 90 or higher. In this patent specification, unless otherwise specified, CRI refers to the General CRI (Ra) that is the average of CRI (R1) to CRI (R8). In an embodiment the white light emitting device is operable to generate white light with a Correlated Color Temperature (CCT) of between 2700K and 3000K and a General CRI (Ra) of 90 or higher. In some embodiments the white light emitting device is additionally operable to generate white light with a CRI (R9) of 90 or higher.

In some embodiments the weight proportion of red-emitting manganese-activated fluoride phosphor (for example potassium hexafluorosilicate phosphor) to yellow to green-emitting phosphor is greater than 50% and more typically is between about 70% and about 90% or about 85%.

According to another embodiment of the invention a white light emitting device comprises: a solid-state light emitter operable to generate blue light with a dominant wavelength in a range 440 nm to 470 nm; a yellow to green-emitting phosphor excitable by blue light and operable to emit light with a peak emission wavelength in a range 500 nm to 575 nm; and a red-emitting manganese-activated potassium hexafluorosilicate phosphor (K₂SiF₆:Mn⁴⁺), excitable by blue light and operable to emit light with a peak emission wavelength between about 631nm and about 632nm; and an orange to red-emitting phosphor excitable by blue light and operable to generate light with a peak emission wavelength in a range 575 nm to 620 nm, wherein the device is operable to generate white light with a Correlated Color Temperature of between 2700K and 3000K, a General Color Rendering Index (Ra) of 90 or higher and a Color Rendering Index (R9) of 90 or higher.

The white light emitting device can further comprise a light transmissive material with an index of refraction of 1.40 to 1.43 comprising a mixture of the yellow to green-emitting phosphor, red-emitting manganese-activated potassium hexafluorosilicate phosphor and the orange to red-emitting phosphor.

The yellow to green-emitting phosphor comprises a cerium-activated green-emitting aluminate phosphor such as a cerium-activated yttrium aluminate (YAG) phosphor; a cerium-activated lutetium aluminate (LuAG) phosphor, or a silicate phosphor.

The orange to red-emitting phosphor comprises any blue light excitable phosphor that emits phosphor light with a peak emission wavelength in a range 580 nm to 620 nm. In some embodiments the orange-emitting phosphor comprises a europium-activated silicon-nitride phosphor such as a CASN (1-1-1-3) or 2-5-8 silicon-nitride phosphors having the general crystalline structure of M'₂Si₅N₈:Eu where M is at least one of Mg, Ca, Sr, Ba, and Zn.

In an embodiment the CASN phosphor can be represented by the chemical formula (Ca₁₋ₓSrₓ)AlSiN₃:Eu where 0.5 < x ≤ 1. In an embodiment the 2-5-8 silicon-nitride phosphor can be represented by the chemical formula Ba₂₋ₓSrₓSi₅N₈:Eu where 0 ≤ x ≤ 2. Preferably, the orange-emitting phosphor generates light with a peak emission wavelength in a range 590 nm to 610 nm.

According to a further embodiment of the invention a white light emitting device comprises: a solid-state light emitter operable to generate blue light with a dominant wavelength in a range 440 nm to 470 nm; a yellow to green-emitting phosphor excitable by blue light and operable to emit light with a peak emission wavelength in a range 500 nm to 550 nm and selected from the group consisting of: a cerium-activated yttrium garnet phosphor; and a cerium-activated lutetium garnet phosphor; a red-emitting manganese-activated potassium hexafluorosilicate phosphor (K₂SiF₆:Mn⁴⁺) excitable by blue light and operable to emit light with a peak emission wavelength between 631nm and 632nm; and an orange to red-emitting europium-activated silicon nitride phosphor excitable by blue light and operable to generate light with a peak emission wavelength in a range 575 nm to 620 nm.

In an embodiment the white light emitting device is operable to generate white light with a Correlated Color Temperature of between 2700K and 3000K and a CRI (Rₐ) of 90 or higher. In some embodiments the white light emitting device is additionally operable to generate white light with a CRI (R9) of 90 or higher.

According to a still further embodiment, a white light emitting device comprises: a solid-state light emitter operable to generate blue light with a dominant wavelength in range 440 nm to 470 nm; a yellow to green-emitting cerium-activated lutetium aluminate phosphor excitable by blue light and operable to emit light with a peak emission wavelength in a range 500 nm to 550 nm; a red-emitting manganese-activated potassium hexafluorosilicate phosphor (K₂SiF₆:Mn⁴⁺) excitable by blue light and operable to emit light with a peak emission wavelength between 631nm and 632nm; and an orange to red-emitting europium-activated silicon nitride phosphor represented by the chemical formula Ba₂₋ₓSrₓSi₅N₈:Eu where 0 ≤ x ≤ 2 excitable by blue light and operable to generate light with a peak emission wavelength in a range 590 nm to 620nm and wherein the device is operable to generate white light with a Correlated Color Temperature of between 2700K and 3000K and a Color Rendering Index (Ra) of 90 or higher.

According to a yet further embodiment, a white light emitting device comprises: a solid-state light emitter operable to generate blue light with a dominant wavelength in range 440 nm to 470 nm; a yellow to green-emitting phosphor excitable by blue light and operable to emit light with a peak emission wavelength in a range 500 nm to 575 nm; a red-emitting manganese-activated potassium hexafluorosilicate phosphor (K₂SiF₆:Mn⁴⁺) excitable by blue light and operable to emit light with a peak emission wavelength between 631 nm and 632 nm; and an orange to red-emitting phosphor excitable by blue light and operable to generate light with a peak emission wavelength in a range 575 nm to 600 nm, wherein the device is operable to generate white light with a Correlated Color Temperature of between about 2700K and about 3000K and wherein over a wavelength range 460 nm to 600 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.3.

It may be that over a wavelength range 460 nm to 500 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.2.

Further, it may be that over a wavelength range 500 nm to 570 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.1.

Preferably, the white light emitting device is operable to generate white light with a General CRI (Ra) of 90 or higher and a CRI (R9) of 90 or higher.

According to another aspect of the invention, a photoluminescence compound comprises: a light transmissive material (encapsulant) with an index of refraction of 1.40 to 1.43 comprising a mixture of a yellow to green-emitting phosphor with a peak emission wavelength in a range 500 nm to 575 nm and a red-emitting manganese-activated fluoride phosphor with an index of refraction of about 1.4. Typically, the mixture of the yellow to green-emitting and red-emitting manganese-activated fluoride phosphors are incorporated (dispersed) in and homogeneously distributed throughout the light transmissive material.

In one embodiment, the red-emitting manganese-activated fluoride phosphor comprises a red-emitting manganese-activated potassium hexafluorosilicate phosphor whose composition can be represented by the chemical formula K₂SiF₆:Mn⁴⁺. K₂SiF₆:Mn⁴⁺ has an index of refraction of about 1.399. It is expected that the present invention finds utility to other red-emitting manganese-activated fluoride phosphors with an index of refraction of about 1.4 and it is believed that manganese-activated fluoride phosphors having these properties may include K₂TiF₆:Mn⁴⁺, K₂SnF₆:Mn⁴⁺, Na₂TiF₆:Mn⁴⁺, Na₂ZrF₆:Mn⁴⁺, Cs₂SiF₆:Mn⁴⁺, Cs₂TiF₆:Mn⁴⁺, Rb₂SiF₆:Mn⁴⁺, Rb₂TiF₆:Mn⁴⁺, K₃ZrF₇:Mn⁴⁺, K₃NbF₇:Mn⁴⁺, K₃TaF₇:Mn⁴⁺, K₃GdF₆:Mn⁴⁺, K₃LaF₆:Mn⁴⁺ and K₃YF₆:Mn⁴⁺.

In some embodiments, the light transmissive material comprises a methyl-based silicone such as a dimethylsiloxane or polydimethylsiloxane.

The yellow to green-emitting phosphor can comprise any phosphor excitable by blue light and operable to emit light with a peak wavelength 500 nm to 575 nm. For general lighting applications, the yellow to green-emitting phosphor comprises a cerium-activated garnet phosphor. Alternatively, and/or in addition, the yellow to green-emitting phosphor can comprise a europium activated silicate phosphor represented by the chemical formula A₂SiO₄:Eu where A is at least one of Mg, Ca, Sr, Ba and combinations thereof. For display backlighting applications the yellow to green-emitting phosphor comprises a narrow-band green-emitting phosphor, preferably a europium-activated β-SiAlON phosphor or europium-activated sulfide phosphor represented by the general formula SrGa₂S₄:Eu.

For general lighting applications, the photoluminescence compound can further comprise an orange to red-emitting phosphor with a peak emission wavelength in a range 580 nm to 620 nm, and wherein the light transmissive material comprises a mixture of the yellow to green-emitting phosphor, red-emitting manganese-activated fluoride phosphor and orange to red-emitting phosphor.

The orange to red-emitting phosphor comprises a europium activated silicon nitride-based phosphor.

The invention finds particular utility when the weight proportion of red-emitting manganese activated potassium hexafluorosilicate phosphor to yellow to green-emitting phosphor is greater than 50% and more typically between 70% and 90% or about 85%.

According to an embodiment of the invention, a display backlight comprising: a solid-state light emitter operable to generate blue light; a narrow-band green-emitting phosphor excitable by blue light and operable to generate light with a peak emission wavelength of about 535 nm; a red emitting manganese-activated potassium hexafluorosilicate phosphor; and a light transmissive material with an index of refraction of 1.40 to 1.43 comprising a mixture of the narrow-band green-emitting phosphor and red-emitting manganese-activated potassium hexafluorosilicate phosphor. In an embodiment, the narrow-band green-emitting phosphor can comprise a europium-activated β-SiAlON phosphor represented by the chemical formula MₓSi₁₂₋₍ₘ₊ₙ₎Alₘ₊ₙOₙN₁₆₋ₙ:Eu where M is at least one Mg, Ca, Sr and combinations thereof, 0.01 < x < 0.1, 0.01 < m < 0.12 and 0.1 < n < 0.5. In another embodiment, the narrow-band green-emitting phosphor can comprise a europium-activated sulfide phosphor represented by the general formula SrGa₂S₄:Eu.

In various embodiments of the invention, the mixture of phosphors or photoluminescence compound can be provided as a part of the LED package, typically on the LED chip(s) or remotely to the solid-state light emitter. In a remote phosphor arrangement, the mixture of phosphors are provided in an optical component that is located remotely to the LED, typically separated from the LED by an air gap.

### DESCRIPTION OF THE DRAWINGS

In order that the present invention is better understood, a LED-based white light emitting devices and photoluminescence compounds in accordance with the invention will now be described, by way of example only, with reference to the accompanying drawings in which like reference numerals are used to denote like parts, and in which:
FIG. **1** is schematic representation of an LED-based white light emitting device in accordance with an embodiment of the invention;
FIG. **2** is a plot of luminous flux versus CIE x for LED-based white light emitting devices for which a) the phosphors are incorporated as a mixture in a phenyl-based silicone and b) the phosphors are incorporated as a mixture in a dimethyl-based silicone;
FIG. **3** is an emission spectrum of an LED-based white light emitting device in accordance with an embodiment of the invention;
FIG. **4** is an emission spectrum of an LED-based white light emitting device (Device 11) in accordance with an embodiment of the invention;
FIG. **5** is an emission spectrum of an LED-based white light emitting device (Device 12) in accordance with an embodiment of the invention ;
FIG. **6** is an emission spectrum of an LED-based white light emitting device (Device 13) in accordance with an embodiment of the invention;
FIG. **7** normalized intensity (normalized to a CIE 1931 XYZ relative luminance Y=100) versus wavelength for (i) Device 14 (solid line), (i) Device 15 (dotted line) and (i) Plankian locus (dashed line) for a CCT of 2700 K;
FIG. **8** normalized intensity deviation (normalized for a CIE 1931 XYZ relative Luminance Y=100) from the black-body curve (2700 K) versus wavelength for Devices 14 and 15;

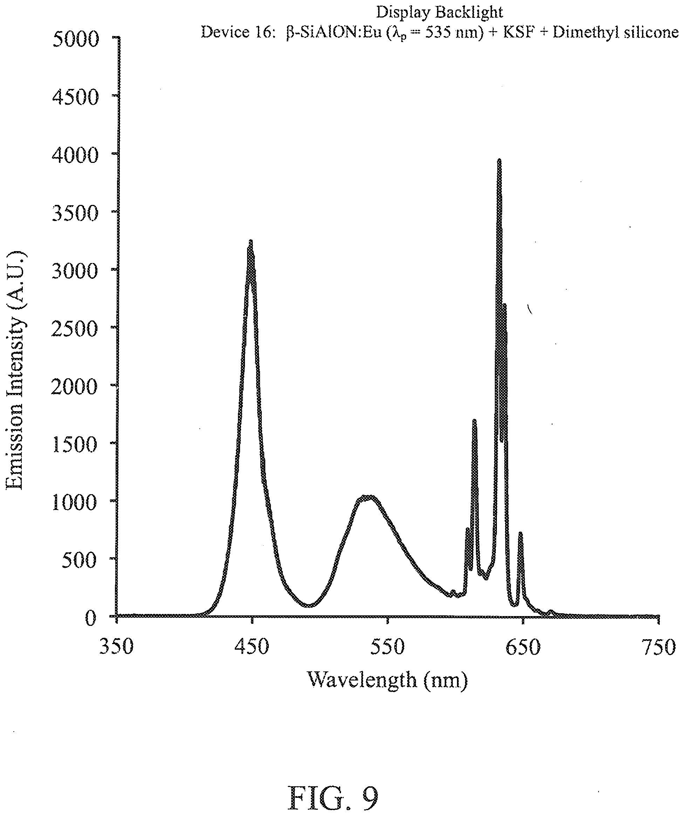

FIG. **9** is an emission spectrum of an LED-based white light emitting device, display backlight (Device 16), in accordance with an embodiment of the invention; and

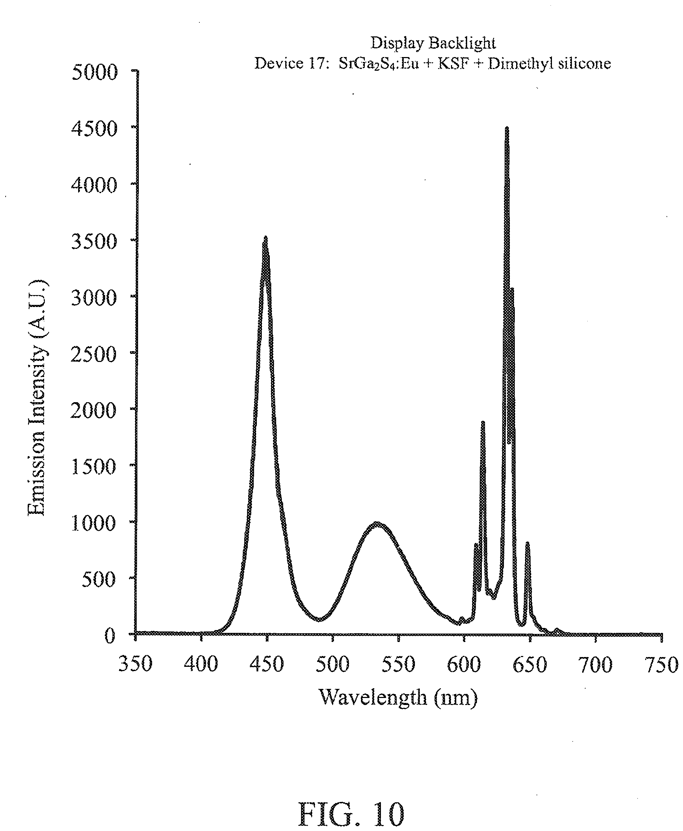

FIG. **10** is an emission spectrum of an LED-based white light emitting device, display backlight (Device 17) in accordance with an embodiment of the invention.

### DETAILED DESCRIPTION OF THE INVENTION

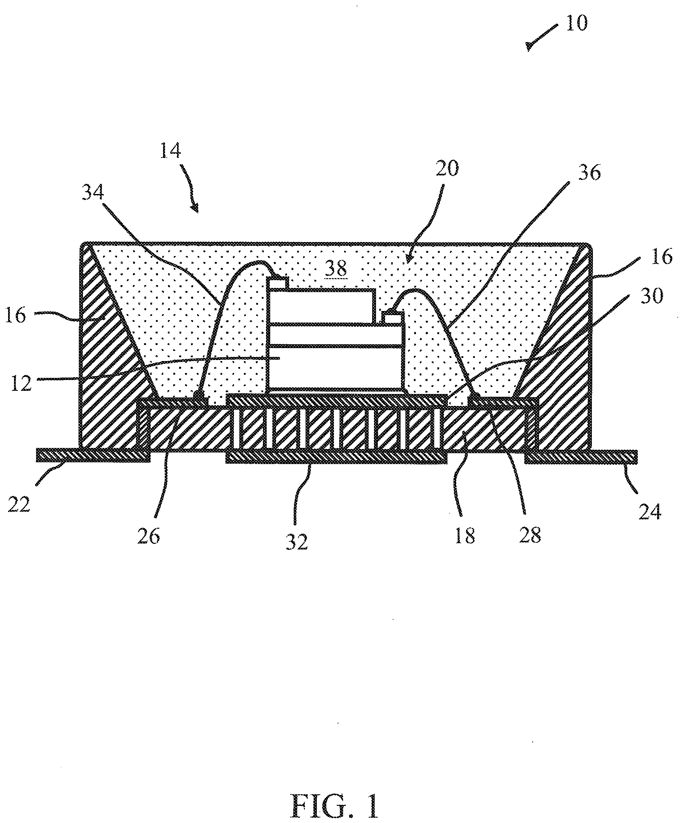

FIG. **1** is a schematic representation of a white light emitting device **10,** according to an embodiment of the invention. The device **10** is configured to generate warm white light with a CCT (Correlated Color Temperature) of approximately 2700 K and a General CRI (Color Rendering Index) CRI (Ra) of 90 and higher.

The device **10** comprises one or more blue-emitting GaN (gallium nitride)-based LED chips **12** that are housed within a package **14.** The one or more LED chips are operable to generate blue light with a dominant wavelength within a range of 440 nm to 470 nm, typically 450 nm to 455 nm. The package, which can for example comprise Surface Mountable Device (SMD) such as an SMD 5630 LED package, comprises upper and lower body parts **16, 18.** The upper body part **16** defines a recess **20** which is configured to receive the one or more LED chips **12.** The package further comprises electrical connectors **22** and **24** on the base that are electrically connected to corresponding electrode contact pads **26** and **28** on the floor of the recess **20.** Using adhesive or solder, the LED chip(s) **12** can be mounted to a thermally conductive pad **30** located on the floor of the recess **20.** The thermally conductive pad **30** is thermally connected to a thermally conductive pad **32** on the base of the package. The LED chip's electrode pads are electrically connected to corresponding electrode contact pads **26** and **28** on the floor of the package using bond wires **34** and **36** and the recess **20** is completely filled with a transparent silicone **38** which is loaded with a mixture of a yellow to green-emitting phosphor, orange to red-emitting phosphor and a red-emitting manganese-activated fluoride phosphor such that the exposed surfaces of the LED chip **12** are covered by the phosphor/silicone material mixture. To enhance the emission brightness of the device the walls of the recess **20** are inclined and have a light reflective surface.

The red-emitting manganese-activated fluoride phosphor comprises a potassium hexafluorosilicate phosphor which can be represented by the chemical formula K₂SiF₆:Mn⁴⁺ excitable by blue excitation light and operable to generate red light with a peak emission wavelength λₚ of about 631 nm to about 632 nm. An example of such a phosphor is NR6931 KSF phosphor from Intematix Corporation, Fremont California, USA which has a peak emission wavelength of 632 nm. For the sake of brevity manganese-activated potassium hexafluorosilicate phosphor and K₂SiF₆:Mn⁴⁺ phosphor will be referred to as "KSF".

The yellow to green-emitting phosphor comprises any phosphor excitable by blue light and operable to generate light with a peak emission wavelength λₚ in a range 500 nm to 575 nm and can include for example silicate-based phosphors, a garnet-based phosphor such as YAG or LuAG phosphors. Examples of such phosphors are given in TABLE **1.**

| **TABLE 1** | | | |
|---|---|---|---|
| Example yellow to green-emitting phosphors | | | |
| Phosphor | General Composition | | Wavelength λₚ (nm) |
| YAG | Y₃₋ₓ(Al_{1-y}Ga_{y})₅O₁₂:Ceₓ | 0.01<x<0.2 & 0<y<2.5 | 520 - 550 |
| LuAG | Lu₃₋ₓ(Al_{1-y}M_{y})₅O₁₂:Ceₓ | 0.01<x<0.2 & 0<y<1.5 M = Mg, Ca, Sr, Ba, Ga, | 500 - 550 |
| LuAG | Lu₃₋ₓ(Al_{1-y}Ga_{y})₅O₁₂:Ceₓ | 0.01<x<0.2 & 0<y<1.5 | 500 - 550 |
| Silicate | A₂SiO₄:Eu | A = Mg, Ca, Sr, Ba | 500 - 550 |
| Silicate | (Srₗ-ₓBaₓₕSiO₄:Eu | 0.3<x<0.9 | 500 - 550 |

In one embodiment the yellow to green-emitting phosphor comprises a green-emitting LuAG-based phosphor as taught in United States Patent US 8,529,791 entitled *"Green-Emitting, Garnet-Based Phosphors in General and Backlighting Applications"* which is hereby incorporated in its entirety. Such a green-emitting phosphor comprises a cerium-activated, green-emitting lutetium aluminate phosphor consisting of lutetium, cerium, at least one alkaline earth metal, aluminum, oxygen, and at least one halogen, wherein the phosphor is configured to absorb excitation radiation having a wavelength ranging from about 380nm to about 480nm, and to emit light having a peak emission wavelength λₚ ranging from about 500nm to about 550nm. An example of such a phosphor is GAL540 phosphor from Intematix Corporation, Fremont California, USA which has a peak emission wavelength of 540nm.

The orange to red-emitting phosphor comprises any phosphor excitable by blue light and operable to emit light with a peak emission wavelength λₚ in a range 580 nm to 620 nm and can include for example a silicate, europium activated silicon nitride-based phosphor or α-SiAlON phosphor. Examples of such orange to red-emitting phosphors are given in TABLE **2.** In one embodiment the orange-emitting phosphor comprises a red-emitting phosphor as taught in United States Patent US 8,597,545 entitled *"Red-Emitting Nitride-Based Calcium-Stabilized Phosphors*" which is hereby incorporated in its entirety. Such a red emitting phosphor comprises a nitride-based composition represented by the chemical formula MₐSr_{b}Si_{c}Al_{d}NₑEu_{f}, wherein: M is Ca, and 0.1 ≤ a ≤ 0.4; 1.5 < b < 2.5; 4.0 ≤ c ≤ 5.0; 0.1 ≤ d ≤ 0.15; 7.5 < e < 8.5; and 0 < f < 0.1; wherein a+b+f >2+d/v and v is the valence of M. Alternatively, the red-emitting phosphor comprises a red light emitting nitride-based phosphor as taught in United States Patent US 8,663,502 entitled *"Red-Emitting Nitride-Based Phosphors"* which is hereby incorporated in its entirety. Such a red emitting phosphor comprising a nitride-based composition represented by the chemical formula M_{(x/v)}M'₂Si₅₋ₓAlₓN₈ :RE, wherein: M is at least one monovalent, divalent or trivalent metal with valence v; M' is at least one of Mg, Ca, Sr, Ba, and Zn; and RE is at least one of Eu, Ce, Tb, Pr, and Mn; wherein x satisfies 0.1 ≤ x<0.4, and wherein said red-emitting phosphor has the general crystalline structure of M'₂Si₅N₈:RE, Al substitutes for Si within said general crystalline structure, and M is located within said general crystalline structure substantially at the interstitial sites. An example of one such a phosphor is XR600 red nitride phosphor from Intematix Corporation, Fremont California, USA which has a peak emission wavelength of 600 nm.

| TABLE **2** | | | |
|---|---|---|---|
| Example orange to red-emitting phosphors | | | |
| Phosphor | General Composition | | Wavelength λₚ (nm) |
| α-SiAlON | Ca_{(x/2)}Si₁₂₋ₓAlₓN₁₆:Eu | 0<x<6 | 580 - 610 |
| α-SiAlON | MₓSi₁₂₋₍ₘ₊ₙ₎Alₘ₊ₙOₙN₁₆₋ₙ:Eu | M=Ca, Sr, Y..; x<2 | 580 - 600 |
| CASN | (Ca₁₋ₓSrₓ)AlSiN₃:Eu | 0.5<x≤1 | 600 - 620 |
| 258 nitride | Ba₂₋ₓSrₓSi₅N₈:Eu | 0≤x≤2 | 580 - 620 |
| Silicate | (BaₓSr₁₋ₓ)₃SiO₅:Eu | 0≤x≤0.2 | 586 - 600 |
| Silicate | (BaₓY_{y}Sr_{1-x-y})₃(Al_{y}Si)O₅:Eu | 0≤x≤02, 0≤y≤0.4 | 600 - 615 |

In accordance with an embodiment of the invention, the material into which the mixture of phosphor materials is incorporated comprises a light transmissive material with an index of refraction n = 1.40 to 1.43. For example the light transmissive material comprises a dimethyl-based silicone such as a polydimethylsiloxane (PDMS). An example of such a suitable silicone material is OE-6370 HF optical encapsulant from Dow Corning.

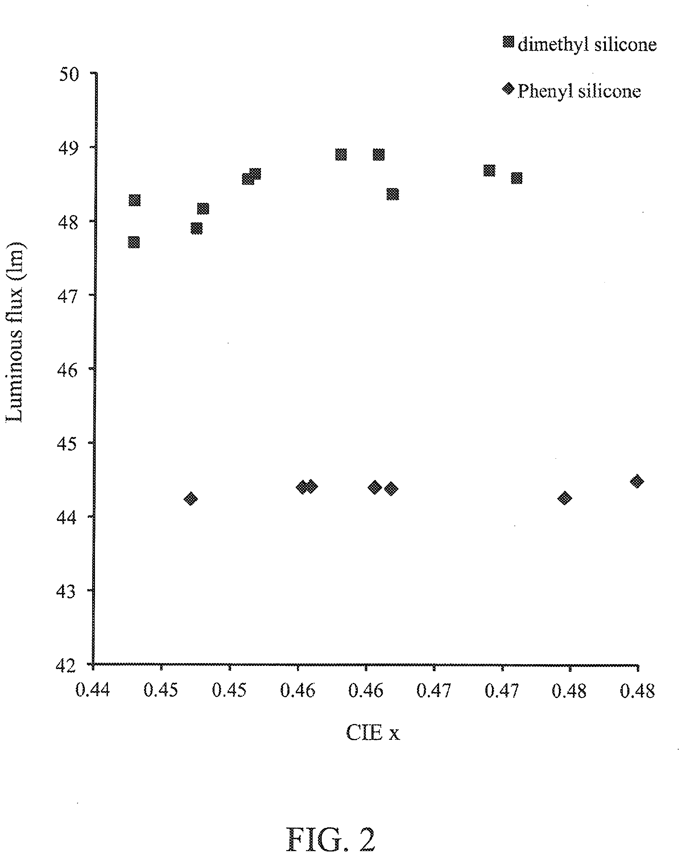

FIG. **2** is a plot of luminous flux versus CIE x for an LED-based white light emitting device in accordance with the invention (■ designated dimethyl silicone OE-6370HF). The variation in CIE x results from different loadings of the phosphor mixture within the silicone. For comparison, data is shown for an identical device in which the same phosphor mixture is incorporated within a phenyl-based silicone (◆ designated phenyl silicone). The phenyl-based silicone used in these devices is OE-6650 optical encapsulant from Dow Corning. Phenyl-based silicone encapsulants are typically used to encapsulate phosphor within LED devices.

FIG. **2** shows that by using a dimethyl-based silicone as the phosphor encapsulant results in about a 10% increase in luminous flux from the device as compared with the same device that uses a phenyl-based silicone as the phosphor encapsulant. It is believed that the increase in luminous flux results from the lower index of refraction (n≈1.4) of the dimethyl-based silicone compared with the index of refraction (n≈1.54) for a phenyl-based silicone. This lower index of refraction is believed to increase red light extraction from the red-emitting manganese-activated potassium hexafluorosilicate (KSF) phosphor which typically have an index of refraction (K₂SiF₆:Mn⁴⁺ - n=1.3991) by reducing total internal reflection at the interface of the phosphor particle and surrounding optical medium (silicone). For comparison, the index of refraction for other phosphors (including the yellow to green-emitting LuAGs and orange-emitting nitrides) is typically around 1.8 which may account for the widespread use of phenyl-based silicone encapsulants in LED-based light-emitting devices. It might be expected that the use of a dimethyl-based silicone would have a detrimental effect on light emission from phosphors other than the red-emitting manganese-activated potassium hexafluorosilicate phosphor (KSF) and degrade the overall performance of the device. However, as shown FIG. **2** when using a red-emitting manganese-activated fluoride phosphor in combination with other phosphor the net result is an increase in luminous flux. The increase in luminous flux is found to be greater when a majority (i.e. more than 50% by weight) of the total phosphor comprises a red-emitting manganese-activated fluoride phosphor. In other embodiments, the yellow to green-emitting, orange to red-emitting (when present) and KSF phosphors can be incorporated as a mixture in other light transmissive materials with an index of refraction of about 1.40 to about 1.43 such as for example a light transmissive epoxy resin.

### Device 1: CCT 2700 K and CRI (Ra) ≥ 90 White Light Emitting Device

TABLES **3A** and **3B** tabulate details of a white light emitting device designated Device 1 which is configured to generate white light with a nominal CCT of 2700 K and a General CRI (Ra) of 90 and higher.

| **TABLE 3A** | | | |
|---|---|---|---|
| Device | Yellow to green-emitting phosphor (Wavelength λₚ) | KSF phosphor (Wavelength λₚ) | Encapsulant |
| 1 | NYAG4454 (558 nm) | NR6931 KSF (632 nm) | OE-6370 HF dimethyl |

Device 1 comprises a SMD 5630 LED package that contains a single 451 nm GaN LED chip with a mixture of two phosphors: (i) a yellow to green-emitting phosphor (Intematix's NYAG4454 cerium-activated green-emitting YAG phosphor) and (ii) a red-emitting manganese-activated fluoride phosphor (Intematix NR6931 KSF). The mixture of phosphors is incorporated in, and homogeneously distributed throughout, a dimethyl-based silicone (Dow Corning OE-6370 HF optical encapsulant). The proportion of KSF phosphor of the total phosphor weight is 86.5 wt % with the remaining 13.5wt % comprising NYAG4454 (TABLE **3B**).

| **TABLE 3B** | | | |
|---|---|---|---|
| Device | Yellow to green-emitting phosphor (wt %) | KSF phosphor (wt %) | Total phosphor content per 100g silicone (g) |
| 1 | 13.5 | 86.5 | 100 |

TABLE **3C** tabulates the optical characteristics of the white light emitting device, Device 1. As can be seen from the table the device generate white light with a CCT ≈2700 K, a General CRI (Ra) of 90 and greater, and a CRI (R9) of greater than 90. Further, as can be seen from TABLE **3C,** Device 1 has a Luminous Efficacy (LE) of 335 lm/W.

| **TABLE 3C** | | | | | | | |
|---|---|---|---|---|---|---|---|
| Device | Luminous Flux (lm) | CIE x | CIE y | CCT (K) | CRI (Ra) | CRI (R9) | LE (lm/W) |
| 1 | 54.0 | 0.4587 | 0.4134 | 2738 | 90.4 | 93.2 | 335 |

### Devices 2 to 10: CCT 2700 K and CRI (Ra) ≥ 95 White Light Emitting Devices

TABLE **4A** tabulates details of various white light emitting devices designated Devices 2 to 10. Devices 2 to 10 are nominally the same device and each is configured to generate white light with a nominal CCT of 2700 K and a General CRI (Ra) of 95 and higher.

| **TABLE 4A** | | | |
|---|---|---|---|
| Device | Yellow to green-emitting phosphor (wt %) | KSF phosphor (wt %) | Orange to red-emitting phosphor (wt %) |
| 2 to 10 | 15 | 82 | 3 |

Each Device comprises a SMD 5630 LED package that contains a single 451 nm GaN LED chip with a mixture of three phosphors: (i) a yellow to green-emitting phosphor (Intematix's GAL540 cerium-activated green-emitting LuAG phosphor), (ii) a red-emitting manganese-activated fluoride phosphor (Intematix NR6931 KSF), and (iii) an orange to red-emitting phosphor (Intematix XR600 nitride-based phosphor). The mixture of phosphors is incorporated in, and homogeneously distributed throughout, a dimethyl-based silicone (Dow Corning OE-6370 HF optical encapsulant). The proportion of red phosphor (XR600 + KSF) of the total phosphor weight is 85 wt % with the remaining 15 wt % comprising GAL540 (TABLE **4A**). The proportion of KSF is 82 wt % and the proportion of XR600 is 3 wt%.

TABLE **4B** tabulates the optical characteristics of the white light emitting devices, Devices 2 to 10. As can be seen from the table each device generates white light with a CCT ≈2700 K, a General CRI (Ra) of 95 and greater, and a CRI (R9) of greater than 92. Further as can be seen from TABLE **4B** the devices have a Luminous Efficacy (LE) ranging between 334 lm/W and 339 lm/W and an average LE of 335 lm/W.

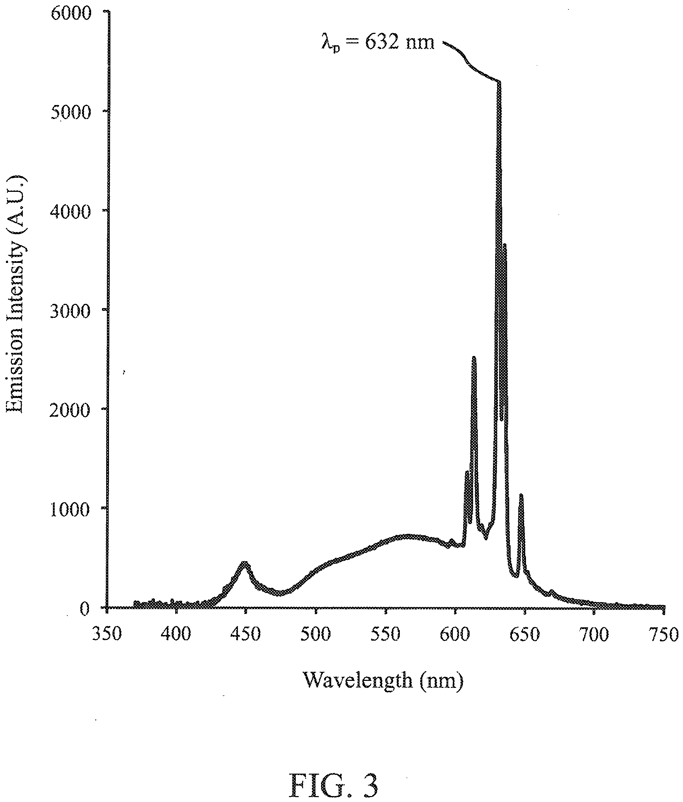

FIG. **3** is an emission spectrum for one of the devices of TABLE **4B.**

| **TABLE 4B** | | | | | | | |
|---|---|---|---|---|---|---|---|
| Devices | Luminous Flux (lm) | CIE x | CIE y | LE (lm/W) | CCT (K) | CRI (Ra) | CRI (R9) |
| 2 | 49.46 | 0.4576 | 0.4048 | 338.9 | 2686 | 96.1 | 92.7 |
| 3 | 48.72 | 0.4560 | 0.4032 | 338.1 | 2696 | 95.9 | 92.4 |
| 4 | 49.07 | 0.4581 | 0.4103 | 335.9 | 2722 | 95.6 | 95.7 |
| 5 | 49.36 | 0.4565 | 0.4067 | 334.4 | 2717 | 94.8 | 96.7 |
| 6 | 49.59 | 0.4564 | 0.4106 | 336.4 | 2748 | 95.6 | 96.0 |
| 7 | 49.17 | 0.4567 | 0.4064 | 333.7 | 2712 | 95.3 | 95.7 |
| 8 | 48.99 | 0.4566 | 0.4069 | 333.9 | 2717 | 95.3 | 96.3 |
| 9 | 49.17 | 0.4599 | 0.4081 | 333.7 | 2680 | 95.0 | 96.3 |
| 10 | 49.15 | 0.4590 | 0.4090 | 335.1 | 2699 | 95.4 | 95.3 |
| Average | 49.19 | 0.4574 | 0.4073 | 335.6 | 2709 | 95.4 | 95.2 |

### Devices 11, 12 and 13: CCT 3000 K. CRI (Ra) ≥ 95 and CRI (R9) ≥ 90 White light emitting devices

TABLES **5A** and **5B** tabulate details of various white light emitting devices designated Devices 11 (ref), 12 and 13. Each Device is configured to generate warm white light with a CCT of approximately 3000 K and comprises a SMD 2835 LED package that contains a single 451 nm GaN LED chip.

| **TABLE 5A** | | | | |
|---|---|---|---|---|
| Device | Yellow to green-emitting phosphor (Wavelength λₚ) | KSF phosphor (Wavelength λₚ) | Orange to red-emitting phosphor (Wavelength λₚ) | Encapsulant |
| 11 (ref) | GAL535 (535 nm) | NR6931 KSF (632 nm) | - | OE-6370 HF dimethyl |
| 12 | GAL540 (540 nm) | NR6931 KSF (632 nm) | XR600 (600 nm) | OE-6370 HF dimethyl |
| 13 | GAL540 (540 nm) | NR6931 KSF (632 nm) | XR600 (600 nm) | OE-6636 phenyl |

Device 11 (ref) comprises a mixture of two phosphors: (i) a yellow to green-emitting phosphor (Intematix's GAL535 cerium-activated green-emitting LuAG phosphor) and (ii) a red-emitting manganese-activated fluoride phosphor (Intematix's NR6931 KSF). The mixture of phosphors is incorporated in, and homogeneously distributed throughout, a dimethyl-based silicone (Dow Corning OE-6370 HF optical encapsulant). The proportion of KSF of the total phosphor weight is 82% wt % with the remaining 18 wt % comprising GAL 535 (TABLE **5B**).

| **TABLE 5B** | | | | | |
|---|---|---|---|---|---|
| Device | Yellow to green-emitting phosphor (wt %) | KSF phosphor (wt %) | Orange to red-emitting phosphor (wt %) | Total phosphor content per 100g silicone (g) | Total phosphor in device (mg) |
| 11 (ref) | 18 | 82 | 0 | 150 | 3.69 |
| 12 | 23.5 | 73.5 | 3 | 110 | 3.44 |
| 13 | 22 | 75 | 3 | 83 | 3.51 |

Device 12 comprises a mixture of three phosphors: (i) a yellow to green-emitting phosphor (Intematix's GAL540 cerium-activated green-emitting LuAG phosphor), (ii) a red-emitting manganese-activated fluoride phosphor (Intematix's NR6931 KSF), and (iii) an orange to red-emitting phosphor (Intematix's XR600 nitride-based phosphor). The mixture of phosphors is incorporated in, and homogeneously distributed throughout, a dimethyl-based silicone (Dow Corning OE-6370 HF optical encapsulant). The proportion of red phosphor (XR600 + KSF) of the total phosphor weight is 76.5 wt % with the remaining 23.5 wt % comprising GAL540 (TABLE **5B**). The proportion of KSF is 73.5 wt % and the proportion of XR600 is 3 wt%.

Device 13 comprises a mixture of three phosphors: (i) a yellow to green-emitting phosphor (Intematix's GAL540 cerium-activated green-emitting LuAG phosphor), (ii) a red-emitting manganese-activated fluoride phosphor (Intematix's NR6931 KSF), and (iii) an orange to red-emitting phosphor (Intematix's XR600 nitride-based phosphor). The mixture of phosphors is incorporated in, and homogeneously distributed throughout, a phenyl-based silicone (Dow Corning OE-6636 optical encapsulant). The proportion of red phosphor (XR600 + KSF) of the total phosphor weight is 78 wt % with the remaining 22 wt % comprising GAL540 (TABLE **5B**). The proportion of KSF is 75 wt % and the proportion of XR600 is 3 wt%.

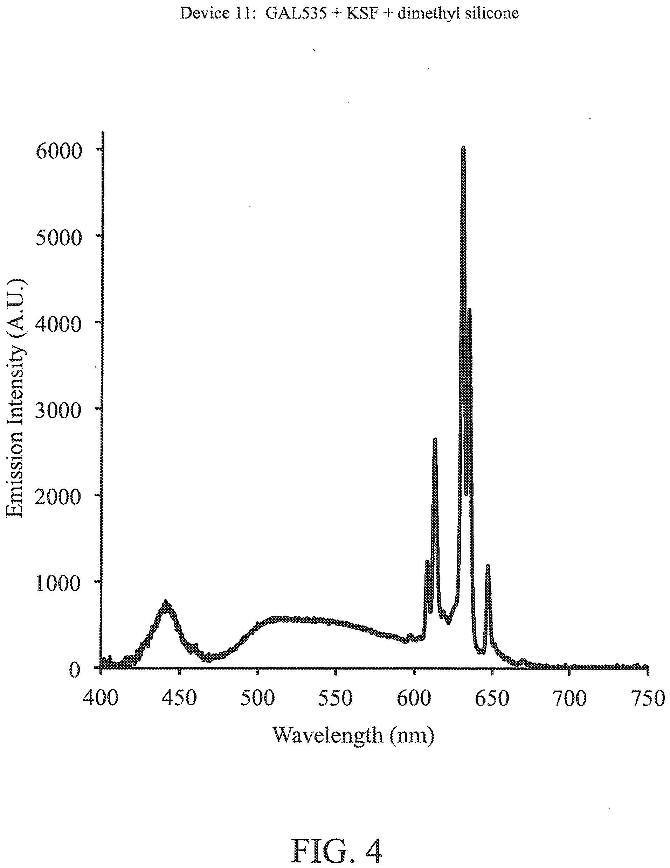

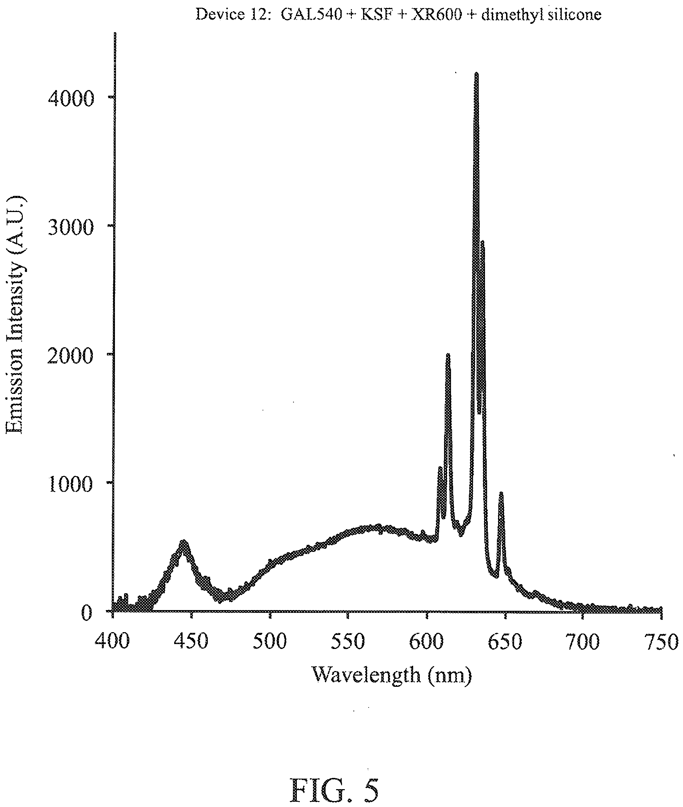

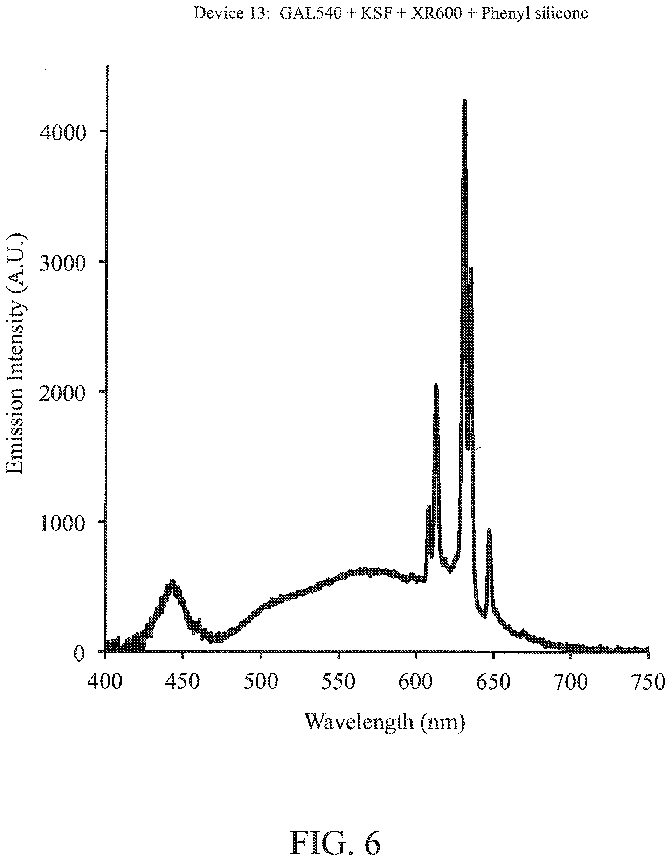

TABLE **5C** tabulates the optical characteristics of the Devices 11 (ref), 12, 13 and FIGS. **4** **,** **5** and **6** respectively show the emission spectra for the Devices 11 (ref), 12 and 13.

The benefits of including a third phosphor (i.e. orange to red-emitting phosphor) in addition to the yellow to green-emitting and KSF phosphors is evidenced by comparing the optical characteristics of Devices 11 (ref) and 12 (TABLE **5C**). It can be seen that the inclusion of a third orange to red-emitting phosphor gives a brightness increase of ≈ 9%, increases the General CRI (Ra) from ≈ 69 to ≈ 95 and increases the CRI (R9) from ≈ 7 to ≈ 93. In summary the benefits of including a third phosphor (i.e. orange to red-emitting phosphor) can be an increase in brightness, an increase in General CRI (Ra) and an increase in CRI (R9).

| **TABLE 5C** | | | | | | | | |
|---|---|---|---|---|---|---|---|---|
| Device | Luminous Flux (lm) | Brightness (%) | CIE x | CIE y | CCT (K) | CRI (Ra) | CRI (R9) | LE (lm/W) |
| 11 (ref) | 40.21 | 100.0% | 0.4162 | 0.3668 | 3057 | 69.3 | 6.8 | 298 |
| 12 | 43.71 | 108.7% | 0.4382 | 0.3999 | 2947 | 94.8 | 92.8 | 334 |
| 13 | 42.30 | 105.2% | 0.4414 | 0.3925 | 2833 | 94.0 | 95.5 | 328 |

The benefits of encapsulating the three phosphor mixture in a dimethyl silicone (more particularly a light transmissive material with an index of refraction n ≈ 1.40 to 1.43) compared with encapsulating the three phosphor mixture in a phenyl silicone can be determined by comparing the optical characteristics of Device 12 with Device 13 (TABLE **5C**). It can be seen that use of a dimethyl silicone increases the brightness by ≈ 2.5% (i.e. 105.2% to 108.7%). The use of a dimethyl silicone, which as described above is believed increases light extraction of light generated by KSF phosphor, which may account for the increase in luminous efficacy (LE). Whilst, when using a dimethyl silicone, overall phosphor usage may increase (110 g per 100 g silicone - Device 12 versus 83 g per 100 g of silicone - Device 13) the substantial increases in brightness, General CRI (Ra) and CRI (R9) potential far outweighs any additional cost increase.

### Devices 14 (ref) and 15: CCT 2700 K White Light Emitting Devices

To further illustrate and explain the benefits of using a three phosphor solution and a phosphor encapsulant having an index of refraction n= 1.40 to 1.43, two further devices, Device 14 (ref) and Device 15 are now discussed. TABLES **6A** and **6B** tabulate details of the white light emitting devices, Device 14 (ref) and Device 15. Each Device is configured to generate warm white light with a CCT of 2700 K and comprises a SMD 5630 LED package that contains a single 451 nm GaN LED chip.

| **TABLE 6A** | | | | |
|---|---|---|---|---|
| Device | Yellow to green-emitting phosphor (Wavelength λₚ) | KSF phosphor (Wavelength λₚ) | Orange to red-emitting phosphor (Wavelength λₚ) | Encapsulant |
| 14 (ref) | GAL535 (535 nm) | NR6931 KSF (632 nm) | - | OE-6370 HF Dimethyl |
| 15 | GAL540 (540 nm) | NR6931 KSF (632 nm) | XR600 (600 nm) | OE-6336 Phenyl |

Device 14 (ref) comprises a mixture of two phosphors: (i) a yellow to green-emitting phosphor (Intematix's GAL535 cerium-activated green-emitting LuAG phosphor) and (ii) a red-emitting manganese-activated fluoride phosphor (Intematix's NR6931 KSF). The mixture of phosphors is incorporated in, and homogeneously distributed throughout, a phenyl-based silicone (Dow Corning OE-6336 optical encapsulant). The proportion of KSF of the total phosphor weight is 82% wt % with the remaining 18 wt % comprising GAL 535 (TABLE **6B**).

| **TABLE 6B** | | | | |
|---|---|---|---|---|
| Device | Yellow to green-emitting phosphor (wt %) | KSF phosphor (wt %) | Orange to red-emitting phosphor (wt %) | Total phosphor content per 100g silicone (g) |
| 14 (ref) | 18 | 82 | 0 | 140 |
| 15 | 23.5 | 73.5 | 3 | 110 |

Device 15 comprises a mixture of three phosphors: (i) a yellow to green-emitting phosphor (Intematix's GAL540 cerium-activated green-emitting LuAG phosphor), (ii) a red-emitting manganese-activated fluoride phosphor (Intematix's NR6931 KSF), and (iii) an orange to red-emitting phosphor (Intematix's XR600 nitride-based phosphor). The mixture of phosphors is incorporated in, and homogeneously distributed throughout, a dimethyl-based silicone (Dow Corning OE-6370 HF optical encapsulant). The proportion of red phosphor (XR600 + KSF) of the total phosphor weight is 76.5 wt % with the remaining 23.5 wt % comprising GAL540 (TABLE **6B**). The proportion of KSF is 73.5 wt % and the proportion of XR600 is 3 wt%.

TABLE **6C** tabulates the optical characteristics of the Devices 14 (ref) and 15. It can be seen that the combined effect of including a third orange to red-emitting phosphor and the use of a dimethyl silicone encapsulant gives a brightness increase of ≈ 12%, an increase in the general CRI (Ra) from ≈ 70 to ≈ 95, an increase in CRI (R9) from ≈ 17 to ≈ 90 and an increase in the luminous efficacy (LE) from ≈ 311 to ≈ 333.

| **TABLE 6C** | | | | | | | | |
|---|---|---|---|---|---|---|---|---|
| Device | Luminous Flux (lm) | Brightness (%) | CIE x | CIE y | CCT (K) | CRI (Ra) | CRI (R9) | LE (lm/W) |
| 14 (ref) | 77 | 100.0% | 0.4579 | 0.4070 | 2699 | 70.3 | 17.3 | 311 |
| 15 | 87 | 112.0% | 0.4598 | 0.4107 | 2701 | 95.8 | 89.5 | 333 |

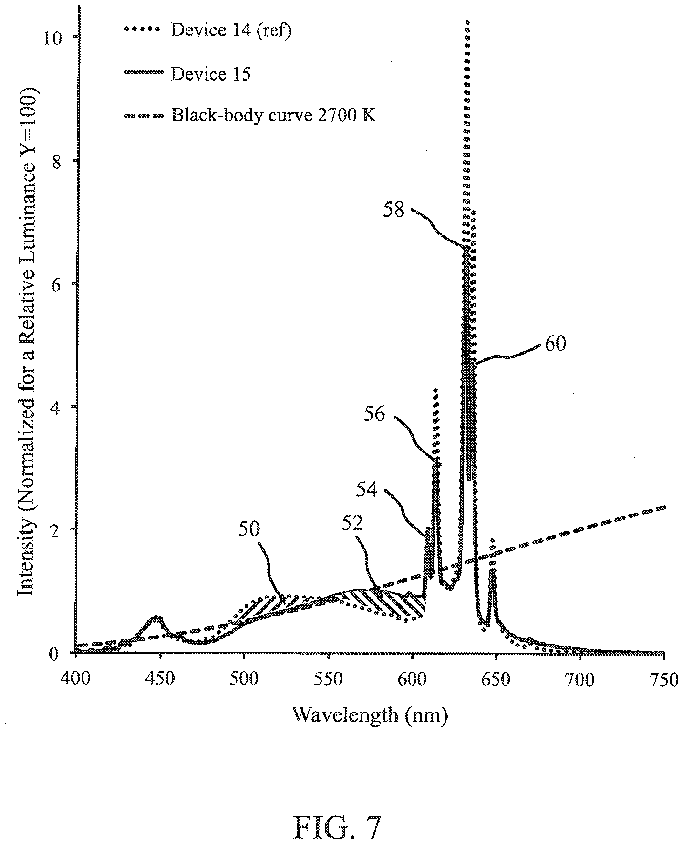

FIG. **7** shows the normalized intensity versus wavelength for (i) the Device 14 (ref) (dotted line), (ii) the Device 15 (solid line) and (iii) black-body curve (dashed line) for a CCT of 2700 K. To make a meaningful comparison of the spectra, each spectra has been normalized such each has a CIE 1931 XYZ relative luminance Y=100. The data are normalized using the CIE 1931 luminosity function *y*(λ) of a standard observer which takes account of the photopic response of an observer.

The Plankian curve or black-body curve (dashed line - FIG. **7**) represents the spectrum for a General CRI (Ra) equal to 100. Accordingly, for a white light emitting device to have the highest color rendering possible, its emission spectrum should match the black-body spectrum as closely as possible.

Referring to FIG. **7** it can be seen that the addition of an orange to red-emitting phosphor and use of encapsulant having an index of refraction that closely matches the index of refraction of the KSF phosphor results in an emission spectrum (solid line) that more closely matches the black-body spectrum (dotted line) in three respects.

First, as indicated by cross hatched area **50,** the green peak between about 500 nm and about 540 nm is reduced such that the emission spectrum (solid line) in this region more closely follows the black-body curve (dotted line). It is postulated that the reduction of the green peak results from the dimethyl silicone which increases light scattering and reduces light extraction from the yellow to green-emitting phosphor.

Second, as indicated by cross hatched area **52,** the valley between about 550 nm and about 610 nm has been filled by the inclusion of the orange to red-emitting phosphor such that the emission spectrum (solid line) in this region more closely follows the black-body curve (dotted line).

Third, it is postulated that the combined effects of including an orange to red-emitting phosphor and use of a dimethyl silicone, reduces the total amount of KSF phosphor which reduces the KSF emission spikes **54, 56, 58, 60** (Device 14 (ref) - 115g KSF per 100g of silicone, Device 15 - 81g KSF per 100g silicone) such that the emission spectrum (solid line) in this region more closely follows the black-body curve (dotted line).

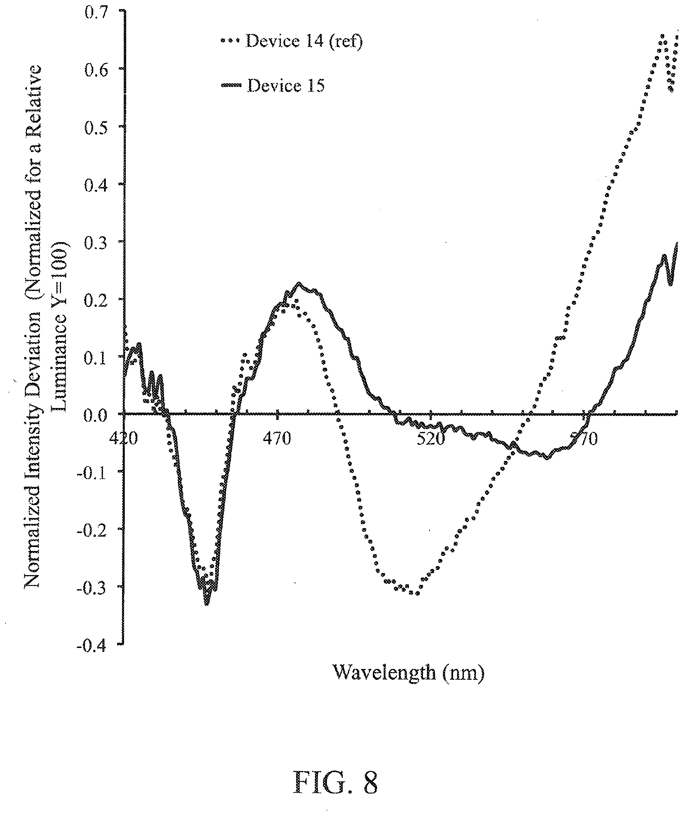

FIG. **8** is a plot of normalized intensity deviation (normalized for a CIE 1931 XYZ relative luminance Y=100) from the black-body curve (2700 K) versus wavelength for the Devices 14 (ref) and 15. As can been from FIG. **8****,** over a wavelength range 460 nm to 500 nm a maximum deviation between the intensity of the light emitted by the device normalized to a CIE 1931 XYZ relative luminance Y=100 compared with the intensity of light of a black-body curve is less than 0.2. Further, it can be seen that over a wavelength range 500 nm to 570 nm a maximum deviation between the intensity of the light emitted by the device normalized to a CIE 1931 XYZ relative luminance Y=100 compared with the intensity of light of a black-body curve is less than 0.1. Hence, it can be seen that the best effects are achieved over the wavelength range of 500 nm to 570 nm where the emission spectrum for Device 15 follows the black-body curve very closely to almost ideal conditions. Across the overall wavelength range of 460 nm to 600 nm, it can be seen that a maximum deviation between the intensity of the light emitted by the device normalized to a CIE 1931 XYZ relative luminance Y=100 compared with the intensity of light of a black-body curve is less than 0.3.

### Display Backlight

While the foregoing embodiments have been described in relation to high CRI white light emitting device for general, embodiments of the invention also find utility in white light emitting devices for use as display backlights. More particularly, although not exclusively, embodiments of the invention concern display backlights for use in high color gamut liquid crystal displays such as for example televisions, computer monitors, laptops, tablet devices and smart phones. In a display backlight the yellow to green-emitting phosphor comprises a narrow-band green-phosphor having a peak emission wavelength that corresponds to the green filter element of the display. Typically, in most liquid crystal displays the peak emission wavelength is about 535 nm (±2 nm). In this specification a narrow-band green-emitting phosphor refers to a phosphor whose emission peak has a FWHM (Full Width Half Maximum) of about 50 nm of less. Examples of suitable narrow-band phosphors are given in TABLE 7. In a backlight the emission spectrum is matched to the color filter plate of the display with red, green and blue components matched to the red, green and blue filters. As a consequence there is no benefit in including an orange to red-emitting phosphor.

| **TABLE 7** | | | | |
|---|---|---|---|---|
| Example narrow-band green-emitting phosphors for white light emitting devices for display backlighting | | | | |
| Phosphor | General Composition | | FWHM (nm) | Wavelength λₚ (nm) |
| Sulfide | SrGa₂S₄:Eu | | 46 - 48 | 536 |
| β-SiAlON:Eu | MₓSi₁₂₋₍ₘ₊ₙ₎Alₘ₊ₙOₙN₁₆₋ₙ:Eu | 0.01<x<0.1; 0.01<m<0.12 & 0.1<n<0.5 M = Sr, Ca Mg | 50 - 52 | 525 - 545 |

### Devices 16 and 17: Display Backlights

TABLES **8A** and **8B** tabulate details of various white light emitting devices designated Devices 16 and 17. Each Device is configured for use as a display backlight and comprises a SMD 5630 LED package that contains a single 452 nm GaN LED chip.

| **TABLE 8A** | | | |
|---|---|---|---|
| Device | Yellow to green-emitting phosphor (Wavelength λₚ) | KSF phosphor (Wavelength λₚ) | Encapsulant |
| 16 | β-SiAlON:Eu (535 nm) | NR6931 KSF (632 nm) | OE-6370 HF dimethyl |
| 17 | SrGa₂S₄:Eu (536 nm) | NR6931 KSF (632 nm) | OE-6370 HF dimethyl |

Device 16 comprises a mixture of two phosphors: (i) a yellow to green-emitting phosphor (narrow-band green-emitting β-SiAlON:Eu phosphor with a peak emission wavelength λₚ = 535 nm) and (ii) a red-emitting manganese-activated fluoride phosphor (Intematix's NR6931 KSF). The mixture of phosphors is incorporated in, and homogeneously distributed throughout, a dimethyl-based silicone (Dow Corning OE-6370 HF optical encapsulant). The proportion of KSF of the total phosphor weight is 82% wt % with the remaining 18 wt % comprising β-SiAlON:Eu phosphor (TABLE **8B**).

| **TABLE 8B** | | | |
|---|---|---|---|
| Device | Yellow to green-emitting phosphor (wt %) | KSF phosphor (wt %) | Total phosphor content per 100g silicone (g) |
| 16 | 24 | 76 | 55 |
| 17 | 14 | 86 | 55 |

Device 17 comprises a mixture of two phosphors: (i) a yellow to green-emitting phosphor (narrow-band green-emitting Sulfide phosphor: SrGa₂S₄:Eu with a peak emission wavelength λₚ = 536 nm) and (ii) a red-emitting manganese-activated fluoride phosphor (Intematix's NR6931 KSF). The mixture of phosphors is incorporated in, and homogeneously distributed throughout, a dimethyl-based silicone (Dow Corning OE-6370 HF optical encapsulant). The proportion of KSF of the total phosphor weight is 82% wt % with the remaining 18 wt % comprising SrGa₂S₄:Eu (TABLE **8B**).

TABLE **8C** tabulates the optical characteristics of the Devices 16 and 17 and FIGS. **4** **9** and **10** respectively show the emission spectra for the Devices 16 and 17. As can be seen from TABLE 4C Devices 16 and 17 respectively produce light with color gamut of % of the NTSC (National Television System Committee) colorimetry 1953 (CIE 1931).

| **TABLE 8C** | | | | | |
|---|---|---|---|---|---|
| Device | Luminous Flux (lm) | Brightness (%) | CIE x | CIE y | Color Gamut % NTSC |
| 16 | 44.01 | 100.0% | 0.2805 | 0.2607 | 88.8 |
| 17 | 44.93 | 102.1% | 0.2806 | 0.2608 | 91.9 |

Although the present invention has been described with particular reference to certain embodiments thereof, it should be readily apparent to those of ordinary skill in the art that changes and modifications in the form and details may be made without departing from the spirit and scope of the invention. For example while embodiments of the invention have been described in relation to manganese-activated potassium hexafluorosilicate phosphor (KSF) it is expected that the present invention finds utility to other manganese-activated fluoride phosphors with an index of refraction of about 1.4 (typically n≈1.39 to ≈1.43). It is believed that such manganese-activated fluoride phosphors having these properties may include K₂TiF₆:Mn⁴⁺, K₂SnF₆:Mn⁴⁺, Na₂TiF₆:Mn⁴⁺, Na₂ZrF₆:Mn⁴⁺, Cs₂SiF₆:Mn⁴⁺, Cs₂TiF₆:Mn⁴⁺, Rb₂SiF₆:Mn⁴⁺, Rb₂TiF₆:Mn⁴⁺, K₃ZrF₇:Mn⁴⁺, K₃NbF₇:Mn⁴⁺, K₃TaF₇:Mn⁴⁺, K₃GdF₆:Mn⁴⁺, K₃LaF₆:Mn⁴⁺ and K₃YF₆:Mn⁴⁺.

## Claims

1. A white light emitting device comprising:
a solid-state light emitter operable to generate blue light with a dominant wavelength in range 440 nm to 470 nm;
a yellow to green-emitting phosphor excitable by blue light and operable to emit light with a peak emission wavelength in a range 500 nm to 575 nm;
a red-emitting manganese-activated potassium hexafluorosilicate phosphor excitable by blue light and operable to emit light with a peak emission wavelength between 631nm and 632nm; and
an orange to red-emitting phosphor excitable by blue light and operable to generate light with a peak emission wavelength in a range 575 nm to 600 nm,
wherein the device is operable to generate white light with a Correlated Color Temperature of between about 2700K and about 3000K and wherein over a wavelength range 460 nm to 600 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.3.

2. The white light emitting device of Claim 1, wherein over a wavelength range 460 nm to 500 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.2.

3. The white light emitting device of Claim 1 or Claim 2, wherein over a wavelength range 500 nm to 570 nm a maximum deviation between the intensity of the light emitted by the device normalized to a CIE 1931 XYZ relative luminance Y=100 compared with the intensity of light of a black-body curve of the same Correlated Color Temperature that is normalized to a CIE 1931 XYZ relative luminance Y=100 is less than 0.1.

4. The white light emitting device of any of Claims 1 to 3, wherein the device is operable to generate white light with a general Color Rendering Index (Ra) of 90 or higher and a Color Rendering Index (R9) of 90 or higher.

5. The white light emitting device of any preceding claim, further comprising a light transmissive material with an index of refraction of 1.40 to 1.43 comprising a mixture of the yellow to green-emitting phosphor, red-emitting manganese-activated potassium hexafluorosilicate phosphor and the orange to red-emitting phosphor.

6. The white light emitting device of Claim 5, wherein the light transmissive material comprises a methyl-based silicone.

7. The white light emitting device of any preceding claim, wherein the yellow to green-emitting phosphor comprises a cerium-activated yttrium garnet phosphor.

8. The white light emitting device of Claim 7, wherein the cerium-activated yttrium garnet phosphor is represented by the chemical formula Y₃₋ₓ(Al_{1-y}Ga_{y})₅O₁₂:Ceₓ where 0.01 < x < 0.2 and 0 < y < 2.5.

9. The white light emitting device of Claim 7 or Claim 8, wherein the cerium-activated yttrium garnet phosphor further comprises at least one of F, Cl and Br.

10. The white light emitting device of any of Claims 1 to 6, wherein the yellow to green-emitting phosphor comprises a cerium-activated lutetium garnet phosphor.

11. The white light emitting device of Claim 10, wherein the cerium-activated lutetium garnet phosphor is represented by the chemical formula Lu₃₋ₓ(Al_{1-y}M_{y})₅O₁₂:Ceₓ where M is at least one of Mg, Ca, Sr, Ba, Ga and combinations thereof, 0.01 < x < 0.2 and 0 < y < 1.5.

12. The white light emitting device of Claim 10 or Claim 11, wherein the cerium-activated lutetium garnet phosphor further comprises at least one of F, Cl and Br.

13. The white light emitting device of any preceding claim, wherein the orange to red-emitting phosphor comprises a europium activated silicon nitride-based phosphor, a phosphor represented by the chemical formula (Ca₁₋ₓSrₓ)AlSiN₃:Eu where 0.5 < x ≤ 1, and/or a phosphor is represented by the chemical formula Ba₂₋ₓSrₓSi₅N₈:Eu where 0 ≤ x ≤ 2.

14. The white light emitting device of any preceding claim, wherein the device is operable to generate white light with a Correlated Color Temperature of between 2700K and 3000K, a general Color Rendering Index (Ra) of 90 or higher and a Color Rendering Index (R9) of 90 or higher.

15. The white light emitting device of any preceding claim, wherein the weight proportion of red-emitting manganese-activated potassium hexafluorosilicate phosphor to yellow to green-emitting phosphor is greater than 50%, optionally wherein the weight percent proportion of the red-emitting manganese-activated potassium hexafluorosilicate phosphor to yellow to green-emitting phosphor is between about 70 wt% and about 90 wt%.
